# FASCICULE DE BREVET EUROPEEN

(11) **EP 0 526 484 B1**
(45) Date de publication et mention de la délivrance du brevet: **16.03.1994**
(21) Numéro de dépôt: 91907553.1
(22) Date de dépôt: 09.04.1991
(51) Int. Cl.: H01F 41/04

(54) **PROCEDE D'ASSEMBLAGE D'UNE BOBINE SUR UN CIRCUIT IMPRIME**
VERFAHREN ZUM MONTIEREN VON EINER SPULE AUF EINE LEITERPLATTE
METHOD FOR ASSEMBLING A COIL ON A PRINTED CIRCUIT

(30) Priorité: 19.04.1990 CH 1329/90
(43) Date de publication de la demande: 10.02.1993
(73) Titulaire: GUSTAFSON, Ake, CH-1618 Châtel-St-Denis (CH)
(72) Inventeur: GUSTAFSON, Ake, CH-1618 Châtel-St-Denis (CH)
(74) Mandataire: Tschudi, Lorenz
(86) Numéro de dépôt international: EP9100672
(87) Numéro de publication internationale: WO9116718

(56) Documents cités:
- CH-A- 632 897
- FR-A- 2 074 150
- PATENT ABSTRACTS OF JAPAN, Vol. 6, No. 243 (E-145)(1121), 02.12.82, & JP-A-57 141907
- PATENT ABSTRACTS OF JAPAN, Vol. 12, No. 500 (699)(3347), 27.12.88, & JP-A-63 211712

## Description

La miniaturisation des circuits électroniques entraîne la nécessité de trouver des solutions nouvelles et originales pour l'assemblage et la connexion des composants miniaturisés, en particulier lorsqu'il est nécessaire de relier les fils d'extrémités d'un bobinage à un circuit imprimé comprenant en outre un ou plusieurs composants discrets ainsi qu'un ou plusieurs circuits intégrés.

De tels circuits comprenant une bobine se trouvent en particulier dans de nombreuses applications dans lesquelles on a une émission et/ou une réception d'un signal électromagnétique à haute fréquence; parmi ces applications, on peut citer la carte de crédit dite "intelligente", ainsi que des appareils de recherche ou de détection sans fil.

Un des problèmes lié à la réalisation de tels circuits vient du très faible diamètre du fil utilisé pour la bobine, rendant ainsi très difficile la saisie des fils d'extrémités du bobinage devant être amenés et soudés sur les pistes correspondantes d'un circuit imprimé. De plus, la fabrication en série, automatique et à haute cadence de ces circuits, afin d'en diminuer le coût de production, nécessite la mise en place de moyens nouveaux pour l'assemblage de la bobine sur le circuit imprimé.

Pour ceci, un procédé a été développé, permettant un assemblage d'une bobine sur un circuit imprimé, en une seule operation, directement sur une machine à bobiner comportant un Flyer, et comprenant les étapes mentionnées dans la partie caractérisante de la revendication 1 lorsqu'on a une bobine sans noyau, et des revendications 2 et 3 lorsqu'on a une bobine avec un noyau.

Le principe et le détail du procédé d'assemblage selon l'invention sont expliqués à partir du dessin annexé avec les figures où :
la figure 1 représente une vue en plan d'une bobine sans noyau en cours d'assemblage avec un circuit imprimé, et
la figure 2 représente une vue en plan d'une bobine comportant un noyau, en cours d'assemblage avec un circuit imprimé.

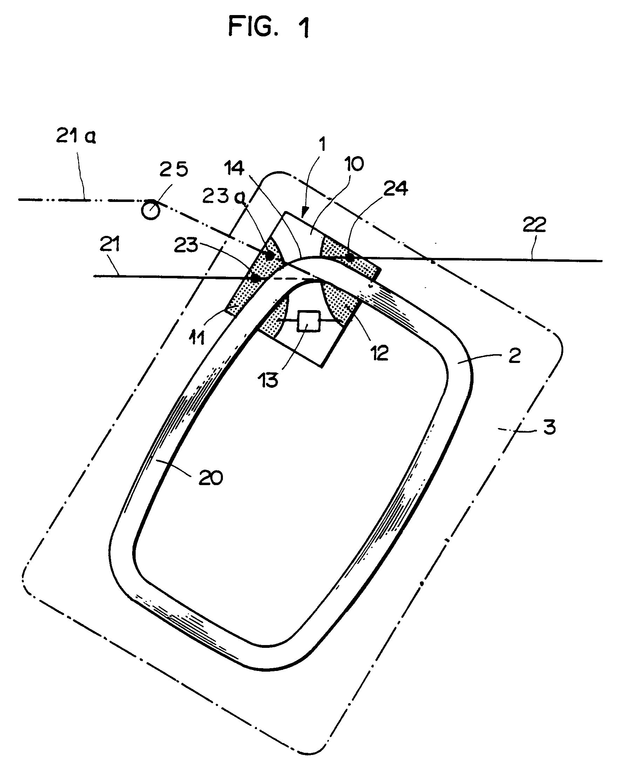

Sur la figure 1, on a tout d'abord un circuit imprimé 1, composé d'un support isolant 10, de faible épaisseur (de l'ordre du dixièmes de mm), comportant en particulier deux pistes métallisées 11 et 12. Un ou plusieurs composants discrets miniaturisés ainsi qu'un ou plusieurs circuits intégrés, tous symbolisés sur la figure par l'élément 13, sont reliés aux deux pistes conductrices 11 et 12. Ce circuit imprimé 1 est tout d'abord mis en place sur la machine à bobiner (non représentée). Pour la constitution du bobinage 2, constitué d'un fil 20 de très faible diamètre (quelques centièmes de mm), la tête de bobinage, soit le Flyer, amène l'extrémité de fil de bobinage 21, toujours reliée à la bobine précédemment bobinée (non représentée), en position pour bobiner le bobinage 2; pour ceci, l'extrémité de fil 21 reste tendue et passe directement au-dessus de la piste métallisée 11, le bobinage s'effectuant sur un gabarit (non représenté) afin de donner la forme requise à la bobine 2. Après que le Flyer aura effectué le nombre de tours correspondant au nombre de spires nécessaires sur la bobine, il quittera la position de bobinage en entraînant l'extrémité de fil de bobinage 22, la faisant passer directement par-dessus la piste métallisée 12 et la menant vers la prochaine bobine à bobiner (non représentée), tout en gardant l'extrémité de fil 22 tendue. On dispose ainsi d'un assemblage, maintenu sur la machine, qu'il suffit maintenant de faire tenir ensemble en disposant des moyens de collage sur la partie isolante 14 du circuit imprimé 1 et en soudant automatiquement l'extrémité de fil de bobinage 21 sur la piste conductrice 11 au point de soudure 23 et l'extrémité de fil de bobinage 22 sur la piste conductrice 12 au point de soudure 24. Il est alors possible de couper ou d'arracher l'extrémité de fil de bobinage 21, avant le point de soudure 23 puis l'extrémité de fil de bobinage 22, après le point de soudure 24, ceci après que le bobinage suivant ait été terminé, pour disposer d'une bobine 2, sans noyau, assemblée de façon fixe sur un circuit imprimé. Il restera alors à compléter le montage d'éventuels composants supplémentaires et d'encapsuler le bobinage et le circuit entre deux couches de plastique pour constituer, par exemple, une carte de crédit 3 dite "intelligente".

Au cas où pour une raison topologique ou pour toute autre raison, il n'est pas avantageux que l'extrémité de fil de bobinage 21 n'arrive pas en droite ligne depuis le bobinage precédent, il est tout à fait possible de modifier l'angle d'arrivée de l'extrémité de fil de bobinage 21a sur le circuit imprimé afin de choisir un autre endroit de la piste métallisée 11 où le point de soudure 23a sera réalisé. Pour ceci, le support maintenant le circuit imprimé comporte un picot fixe de guidage 25, au-dessus duquel passe le Flyer, afin de guider convenablement le fil d'extrémité de bobinage 21a. Cette situation est représentée en traits mixtes sur la figure; il est bien évident qu'elle peut aussi s'appliquer pour le choix d'un autre endroit pour la soudure du point 24 du fil d'extrémité de bobinage 22.

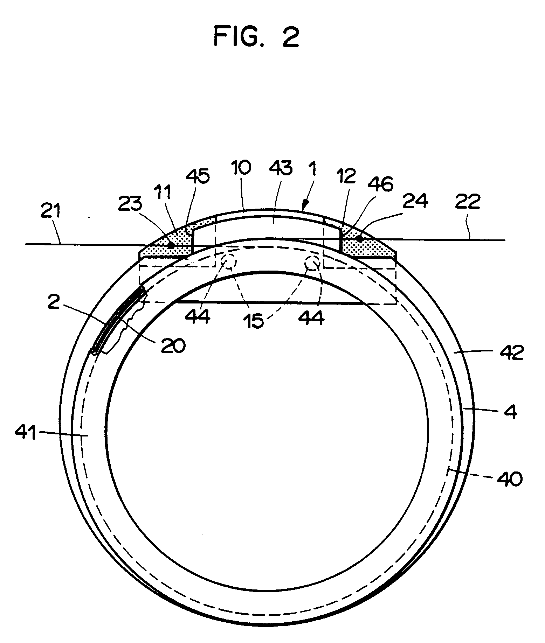

On retrouve certains des éléments précédemment mentionnés sur la figure 2, soit un circuit imprimé 1 constitué d'un support isolant mince 10 et comportant deux pistes conductrices 11 et 12. Un noyau de bobine 4 en matière synthétique est constitué d'un fût cylindrique, représenté par le trait interrompu 40, d'une joue avant 41, concentrique au fût 40, et d'une joue arrière 42, excentrique par rapport au fût 40 et à la joue avant 41. La bobine 2 de fil fin 20 sera bobinée dans l'espace situé entre la surface extérieure du fût 40 et les deux faces internes des joues avant 41 et arrière 42. La joue arrière 42 est excentrique afin de présenter une surface d'appui 43, sur laquelle viendra s'appuyer le circuit imprimé 1 maintenu par deux saillies 44 du noyau 4, coopérant avec deux trous 15 percés dans le support 10 du circuit imprimé 1, afin de maintenir ensemble ces deux éléments. La joue arrière 42 présente en outre deux encoches 45 et 46 qui viennent en face des deux pistes conductrices 11 et 12 du circuit imprimé 1. Ainsi, lorsque le circuit imprimé 1 aura été mis en place sur la machine à bobiner, que le noyau 4 lui aura été superposé et fixé par l'intermédiaire des saillies 44 et des trous 15, le Flyer (non représenté) pourra amener, de la même manière que précédemment, l'extrémité de fil 21 et commencer le bobinage par-dessus le fût 40 en ayant passé le fil 21 immédiatement au-dessus de la piste conductrice 11. Lorsque le nombre de spires nécessaires aura été bobiné, le Flyer entraînera le fil d'extrémité 22 vers la prochaine bobine à bobiner, en passant immédiatement au dessus de la piste conductrice 12; comme précédemment, les points de soudure 23 et 24 fixent les fils d'extrémités 11 et 12 sur les pistes conductrices respectives 21 et 22. Après coupure ou arrachage des extrémités libres de fils avant et après les points de soudure 32 et 24, et retrait de l'ensemble constitué d'une bobine 2 sur un noyau 4 assemblé avec un circuit imprimé 1, on dispose d'un assemblage fixe pouvant être intégré dans un circuit électronique. Comme précédemment, d'autres composants ou circuits intégrés, (non représentés) pouvaient déjà avoir été fixés au circuit imprimé avant son assemblage avec la bobine. Il est aussi possible de modifier l'angle d'arrivée ou de départ des fils 21 et 22, en disposant un ou deux picots de guidage, ce qui permet de choisir convenablement les endroits où se feront les soudures.

Diverses variantes dans les procédés décrits ci-dessus peuvent être mentionnées, qui toutes entrent dans le cadre de la protection offerte par les revendications; en particulier, la fixation des composants discrets et/ou du ou des circuits intégrés sur le circuit imprimé peut se faire soit avant que le circuit imprimé ne soit assemblé à la bobine, soit après cette opération; de même, la fixation du noyau sur le circuit imprimé peut se faire avant ou après avoir mis en place celui-ci sur la machine à bobiner. Pour l'opération de soudure des extrémités de fils de bobinage sur les pistes conductrices, il est important que lesdites extrémités de fils soient maintenues et tendues d'une manière quelconque avant d'effectuer les soudures, c'est la seule manière de pouvoir vraiment rationaliser la production de tels circuits puisqu'il n'est alors pas nécessaire de rechercher une ou deux extrémités de fils de bobinage extrêmement fins, opération hasardeuse, difficile et longue, donc coûteuse.

Ainsi, en effectuant la soudure des fils d'extrémités du bobinage sur les pistes métallisées correspondantes du circuit imprimé, alors qu'ils sont encore maintenus d'une manière ou d'une autre dans la machine à bobiner, il est possible par ce procédé d'obtenir une productivité accrue de la fabrication de circuits électroniques miniaturisés comprenant un bobinage; de plus, les procédés décrits permettent la réalisation de circuits extrêmement minces, vu que l'épaisseur totale du circuit n'est constituée que de l'épaisseur de la bobine à laquelle se superpose une épaisseur du circuit imprimé, constitué lui-même d'une feuille très mince. Ces qualités avantageuses sont obtenues par le fait que les fils d'extrémités du bobinage sont soudées sur des pistes disposées à l'extérieur du bobinage, alors que les autres éléments du circuit électronique, respectivement le circuit intégré, sont logés dans l'espace situé au centre de la bobine, ledit espace étant d'une dimension, respectivement d'une épaisseur suffisante pour accepter ces autres éléments de circuit.

## Revendications

1. Procédé d'assemblage d'une bobine (2) sans noyau sur un circuit imprimé (1) comprenant en particulier deux pistes métallisées (11,12) destinées à recevoir les fils d'extrémités (21,22) du bobinage (20), caractérisé en ce qu'il comprend les étapes suivantes:
mise en place du circuit imprimé (1) sur la machine à bobiner, les pistes métallisées (11,12) étant accessibles pour le soudage,
réalisation du bobinage (20) par un Flyer, en face du circuit imprimé installé à l'étape précédente, les fils d'extrémités (21,22) de bobinage étant conservés-tendus et passant chacun sur la piste métallisée qui lui correspond,
collage du bobinage (20) sur le circuit imprimé (1),
soudure (23,24) de chacun desdits fils d'extrémités sur la piste métallisée qui lui correspond, et
coupure ou arrachage des extrémités libres des fils d'extrémités de bobinage.

2. Procédé d'assemblage d'une bobine (2) munie d'un noyau (4) en matière synthétique constitué d'un fût cylindrique (40), d'une joue avant (41) et d'une joue arrière (42) présentant une surface d'appui (43), sur un circuit imprimé (1) comprenant en particulier deux pistes métallisées (11,12) destinées à recevoir les fils d'extrémités (21,22) du bobinage, caractérisé en ce qu'il comprend les étapes suivantes:
mise en place du circuit imprimé (1) sur la machine à bobiner, les pistes métallisées (11,12) étant accessibles pour le soudage et fixation du noyau de bobine (4) sur le circuit imprimé par l'intermédiaire de moyens de fixation (15,44) disposés sur ladite surface d'appui (43), deux encoches (45,46) étant disposées en face des deux pistes métallisées (11,12),
réalisation du bobinage (20) par un Flyer sur le noyau de bobine dans l'espace situé entre la surface extérieure du fût (40) et les deux surfaces internes des joues avant (41) et arrière (42), les fils d'extrémités (21,22) de bobinage étant conservés tendus et passant chacun sur la piste métallisée qui lui correspond,
soudure (23,24) de chacun desdits fils d'extrémités sur la piste métallisée qui lui correspond,
et coupure ou arrachage des extrémités libres des fils d'extrémités de bobinage.

3. Procédé d'assemblage d'une bobine (2) munie d'un noyau (4) en matière synthétique constitué d'un fût cylindrique (40), d'une joue avant (41) et d'une joue arrière (42) présentant une surface d'appui (43), sur un circuit imprimé (1) comprenant en particulier deux pistes métallisées (11,12) destinées à recevoir les fils d'extrémités (21,22) du bobinage, caractérisé en ce qu'il comprend les étapes suivantes:
fixation du noyau de bobine (4) sur le circuit imprimé par l'intermédiaire de moyens de fixation (15,44) disposés sur ladite surface d'appui (43), deux encoches (45,46) étant disposées en face des deux pistes métallisées (11,12),
mise en place du noyau (4) sur la machine à bobiner, les pistes métallisées (11,12) du circuit imprimé (1) étant accessibles pour le soudage
et réalisation du bobinage (20) par un Flyer sur le noyau de bobine dans l'espace situé entre la surface extérieure du fût (40) et les deux surfaces internes des joues avant (41) et arrière (42), les fils d'extrémités (21,22) de bobinage étant conservés tendus et passant chacun sur la piste métallisée qui lui correspond,
soudure (23, 24) de chacun desdits fils d'extrémités sur la piste métallisée qui lui correspond, et
coupure ou arrachage des extrémités libres des fils d'extrémités de bobinage.

4. Procédé selon l'une des revendications 1 ou 2, caractérisé en ce que le circuit imprimé comprend déjà tout ou partie de ses composants (13), à l'exception de la bobine, avant d'être mis en place sur la machine à bobiner.

## Patentansprüche

1. Verfahren zum Montieren einer Spule (2) ohne Kern auf einer Leiterplatte (1), welche im wesentlichen zwei metallisierte Bahnen (11, 12) umfasst, die dazu bestimmt sind, die Drahtenden (21, 22) der Spulenwicklung (20) aufzunehmen, gekennzeichnet durch die folgenden Verfahrensschritte:
Anordnen der Leiterplatte (1) auf der Wickelmaschine, derart, dass die metallisierten Bahnen (11, 12) zum Anbringen von Lötstellen zugänglich bleiben,
Erstellen der Spulenwicklung (20) gegenüber der Leiterplatte, die im vorhergehenden Schritt angeordnet worden ist, mit einem Flyer, wobei die Drahtenden (21, 22) der Spulenwicklung gespannt gehalten werden und jedes davon über die ihm zugeordnete metallisierte Bahn geführt wird,
Aufkleben der Spulenwicklung (20) auf die Leiterplatte (1),
Verlöten (23, 24) von jedem der genannten Drahtenden auf der ihm zugeordneten metallisierten Bahn, und
Abschneiden oder Abreissen der freien Enden der Drahtenden der Spulenwicklung.

2. Verfahren zum Montieren einer Spule (2), die mit einem Kern (4) aus synthetischem Material versehen ist, der einen zylindrischen Schaft (40), eine vordere Wange (41) und eine hintere Wange (42), die eine Anliegefläche (43) umfasst, aufweist, auf einer Leiterplatte (1), die im wesentlichen zwei metallisierte Bahnen (11, 12) umfasst, die zum Aufnehmen der Drahtenden (21, 22) der Spulenwicklung bestimmt sind, gekennzeichnet durch die folgenden Verfahrensschritte:
Anordnen der Leiterplatte (1) auf der Wickelmaschine, wobei die metallisierten Bahnen (11, 12) zum Anbringen von Lötstellen zugänglich bleiben, und Befestigung des Kernes (4) der Spule auf der Leiterplatte unter Zuhilfenahme von Befestigungsmitteln (45, 44), die auf der genannten Anliegefläche (43) angeordnet sind, wobei zwei Kerben (45, 46) sich gegenüber den zwei metallisierten Bahnen (11, 12) befinden,
Erstellen der Spulenwicklung (20) auf dem Spulenkern in einem Raum, der sich zwischen der äusseren Oberfläche des Schaftes (40) und den zwei inneren Oberflächen der vorderen (41) und der hinteren Wange (42) befindet, mit einem Flyer, wobei die Drahtenden (21, 22) der Spulenwicklung gespannt gehalten werden, und jedes davon über die ihm zugeordnete metallisierte Bahn geführt wird,
Verlöten (23, 24) von jedem der genannten Drahtenden auf der ihm zugeordneten metallisierten Bahn, und
Abschneiden oder Abreissen der freien Enden der Drahtenden der Spulenwicklung.

3. Verfahren zum Montieren einer Spule (2), die mit einem Kern (4) aus synthetischem Material versehen ist, der einen zylindrischen Schaft (40), eine vordere Wange (41) und eine hintere Wange (42), die eine Anliegefläche (43) umfasst, aufweist, auf einer Leiterplatte (1), die im wesentlichen zwei metallisierte Bahnen (11, 12) umfasst, die zum Aufnehmen der Drahtenden (21, 22) der Spulenwicklung bestimmt sind, gekennzeichnet durch die folgenden Verfahrensschritte:
Befestigen des Kernes (4) der Spule auf der Leiterplatte unter Zuhilfenahme von Befestigungsmitteln (15, 44), die auf der genannten Anliegefläche (43) angeordnet sind, wobei zwei Kerben (45, 46) gegenüber den zwei metallisierten Bahnen (11, 12) angeordnet sind,
Anordnen des Kernes (4) auf der Wickelmaschine, wobei die metallisierten Bahnen (11, 12) der Leiterplatte (1) zum Anbringen von Lötstellen zugänglich bleiben, und
Erstellen der Spulenwicklung (20) auf dem Spulenkern in einem Raum, der sich zwischen der äusseren Oberfläche des Schaftes (40) und zwischen den zwei inneren Flächen der vorderen (41) und hinteren Wange (42) befindet, mit einem Flyer, wobei die Drahtenden (21, 22) der Spulenwicklung gespannt gehalten werden und jedes davon über die ihm zugeordnete metallisierte Bahn geführt wird,
Verlöten (43, 24) von jedem der genannten Drahtenden auf der ihm zugeordneten metallisierten Bahn, und
Abschneiden oder Abreissen der freien Enden der Drahtenden der Spulenwicklung.

4. Verfahren nach einem der Ansprüche 1 oder 2, dadurch gekennzeichnet, dass die Leiterplatte, bevor sie auf der Wickelmaschine angeordnet wird, mit Ausnahme der Spule bereits mit allen oder einem Teil seiner Bauteile versehen wird.

## Claims

1. Process for assembly of an air-core coil (2) on a printed circuit (1) comprising in particular two metallized tracks (11, 12) intended to receive the end wires (21, 22) of the winding (20), characterized in that it comprises the following steps:
placing the printed circuit (1) on the winding machine, the metallized tracks (11, 12) being accessible for soldering,
producing the winding (20) by a flyer, opposite the printed circuit installed in the preceding step, the winding end wires (21, 22) being kept taut and each passing on the metallized track which corresponds to it,
gluing of the winding (20) on the printed circuit (1), soldering (23, 24) of each of said end wires on the metallized track which corresponds to it, and
cutting or tearing of the free ends of the winding end wires.

2. Process for assembly of a coil (2) provided with a core (4) of synthetic material made up of a cylindrical barrel (40), of a front flange (41), and of a rear flange (42) having a support surface (43), on a printed circuit (1) comprising in particular two metallized tracks (11, 12) intended to receive the end wires (21, 22) of the winding, characterized in that it comprises the following steps:
placing the printed circuit (1) on the winding machine, the metallized tracks (11, 12) being accessible for soldering and fixing of the coil core (4) on the printed cirucuit (1) through the intermediary of fixing means (15, 44) disposed on said support surface (43), two notches (45, 46) being disposed opposite the two metallized tracks (11, 12),
producing the winding (20) by a flyer on the coil core in the space situated between the outside surface of the barrel (40) and the two inner surfaces of the front (41) and rear (42) flanges, the winding end wires (21, 22) being kept taut and each passing on the metallized track which corresponds to it,
soldering (23, 24) of each of said end wires on the metallized track which corresponds thereto,
and cutting or tearing of the free ends of the winding end wires.

3. Process for assembly of a coil (2) provided with a core (4) of synthetic material made up of a cylindrical barrel (40), of a front flange (41), and of a rear flange (42) having a support surface (43), on a printed circuit (1) comprising in particular two metallized tracks (11, 12) intended to receive the end wires (21, 22) of the winding, characterized in that it comprises the following steps:
fixing of the coil core (4) on the printed circuit through the intermediary of fixing means (15, 44) disposed on said support surface (43), two notches (45, 46) being disposed opposite the two metallized tracks (11, 12),
placing the core (4) on the winding machine, the metallized tracks (11, 12) of the printed circuit (1) being accessible for soldering
and producing the winding (20) by a flyer on the coil core in the space situated between the outside surface of the barrel (40) and the two inner surfaces of the front (41) and rear (42) flanges, the winding end wires (21, 22) being kept taut and each passing on the metallized track which corresponds to it,
soldering (23, 24) of each of said end wires on the metallized track corresponding to it, and
cutting or tearing of the free ends of the winding end wires.

4. Process according to one of the claims 1 or 2, characterized in that the printed circuit (1) already comprises all or part of its components (13), with the exception of the coil, before being placed on the winding machine.
